# EUROPEAN PATENT APPLICATION

(11) **EP 4 350 733 A1**
(43) Date of publication of application: **10.04.2024**
(21) Application number: 22200380.8
(22) Date of filing: 07.10.2022
(51) Int. Cl.: H01J 37/04, H01J 37/12

(54) **ELECTRON-OPTICAL MODULE**

(71) Applicant: ASML Netherlands B.V., 5500 AH Veldhoven (NL)
(72) Inventor: DE LANGEN, Johannes, Cornelis, Jacobus, 5500 AH Veldhoven (NL); KONING, Johan, Joost, 5500 AH Veldhoven (NL); DEL TIN, Laura, 5500 AH Veldhoven (NL); DOESBURG, Olivier, Jacob, 5500 AH Veldhoven (NL); ZIJL, Gomaar, 5500 AH Veldhoven (NL)
(74) Representative: ASML Netherlands B.V.

(57) **Abstract**

A charged particle-optical module 41 for directing charged particles along a path towards a sample location, the charged particle-optical module comprises: a plurality of planar elements or electrodes 61-64 arranged across the path and configured to operate on the charged particles; a thermal conditioning channel 80 spaced from the planar elements in a direction through the plurality of elements; and a thermally conductive plate 61-64;240;75 connected to the thermal conditioning channel for transferring heat towards the thermal conditioning channel; wherein the thermally conductive plate extends between the planar elements and the thermal conditioning channel in a direction parallel to one or more of the planar elements.

## Description

### FIELD

The embodiments provided herein generally relate to a charged particle-optical module, a charged particle-optical device, a charged particle-optical apparatus and a method for moderating a temperature of one or more components of a charged particle-optical module.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection apparatus has a single beam and may be referred to as a Single Beam SEM. There have been attempts to introduce a multi-electron beam inspection in a apparatus (or a multi-beam tool') which may be referred to as Multi Beam SEM (MBSEM).

Another application for an electron-optical device (or column) is lithography. The charged particle beam reacts with a resist layer on the surface of a substrate. A desired pattern in the resist can be created by controlling the locations on the resist layer that the charged particle beam is directed towards.

An electron-optical device may be an apparatus for generating, illuminating, projecting and/or detecting one or more beams of charged particles. The path of the beam of charged particles is controlled by electromagnetic fields (i.e. electrostatic fields and magnetic fields). Stray electromagnetic fields can undesirably divert the beam.

During use of some electron-optical devices, the energy from the electron beam(s) heats the electron-optical elements. It can be difficult to moderate the temperature of components of the electron-optical device.

### SUMMARY

The present invention provides a suitable architecture to enable improved control of temperatures within the electron-optical apparatus.

According to a first aspect of the invention, there is provided a charged particle-optical module for directing charged particles along a beam path towards a sample location, the charged particle-optical module comprising: a plurality of planar elements arranged across the beam path and configured to operate on the charged particles; a thermal conditioning channel spaced from the planar elements in a direction through the plurality of elements; and a thermally conductive plate connected to the thermal conditioning channel for transferring heat towards the thermal conditioning channel; wherein the thermally conductive plate extends between the planar elements and the thermal conditioning channel in a direction parallel to one or more of the planar elements.

According to a second aspect of the invention, there is provided a method for moderating a temperature of one or more components of a charged particle-optical module for directing charged particles along a beam path towards a sample location, the method comprising: arranging a plurality of planar elements across the beam path to operate on the charged particles, for example mounting the module into a charged particle-optical device of a charged particle-optical apparatus; spacing a thermal conditioning channel from the planar elements in a direction through the plurality of elements; and transferring heat towards the thermal conditioning channel through a thermally conductive plate connected to the thermal conditioning channel; wherein the thermally conductive plate extends between the planar elements and the thermal conditioning channel in a direction parallel to one or more of the planar elements.

According to a third aspect of the invention, there is provided a method for moderating a temperature of one or more components of a charged particle-optical module for use in a charged particle-optical apparatus to direct charged particles along a beam path towards a sample location, the charged particle-optical module comprising a plurality of planar elements configured to operate on charged particles, a thermal conditioning channel spaced away from the plurality of planar elements, and a thermally conductive plate extending between and in thermal contact with the plurality of planar elements and the thermal conditioning channel, the method comprising: operating the charged particle-optical apparatus to project charged particles to a sample location; flowing thermal conditioning fluid through the thermal conditioning channel; and transferring heat towards the thermal conditioning channel through the thermally conductive plate.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary electron beam inspection apparatus.
Figure 2 is a schematic diagram illustrating an exemplary multi-beam electron-optical device that is part of the exemplary electron beam inspection apparatus of Figure 1.
Figure 3 is a schematic diagram of an exemplary electron-optical device comprising a collimator element array and a scan-deflector array that is part of the exemplary electron beam inspection apparatus of Figure 1.
Figure 4 is a schematic diagram of an exemplary electron-optical device array comprising the electron-optical devices of Figure 3.
Figure 5 is a schematic diagram of an alternative exemplary electron-optical device that is part of the exemplary electron beam inspection apparatus of Figure 1.
Figure 6 is a schematic diagram of an exemplary electron-optical assembly that may be part of the electron-optical devices of Figures 3, 4 and 5.
Figure 7 is a schematic diagram of an exemplary electron-optical assembly that may be part of the electron-optical devices of Figures 3, 4 and 5.
Figure 8 is a schematic plan view of an exemplary electron-optical assembly.
Figure 9 is a schematic plan view of a cross-section of the exemplary electron-optical assembly shown in Figure 8.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION OF FIGURES

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by inspection systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of electron-optical apparatus embodying these scanning electron microscope features may have a single beam. For higher throughput such as for inspection, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam inspection apparatus may therefore inspect a target much quicker, e.g. by moving the target at a higher speed, than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the signal particles (e.g. secondary electrons) from the target when they are detected, for example the shape and size of the spot formed by the sub-beam on the target will be affected. Such aberrations therefore degrade the quality of resulting images that are created during inspection.

An implementation of a known multi-beam inspection apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

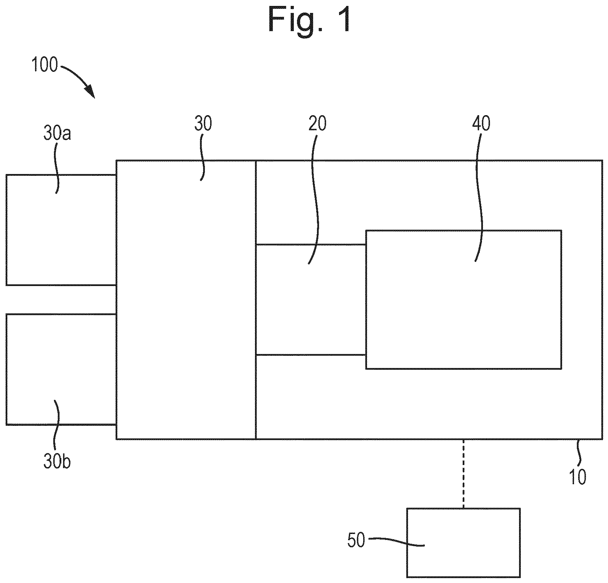

Reference is now made to Figure 1, which is a schematic diagram illustrating an exemplary electron beam assessment apparatus, or inspection apparatus, 100. The inspection apparatus 100 of Fig. 1 includes a vacuum chamber 10, a load lock chamber 20, an electron-optical apparatus, an equipment front end module (EFEM) 30 and a controller 50. The electron-optical device 40 may be within the vacuum chamber 10. The electron-optical apparatus may comprise an electron-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be inspected (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical device 40 by which it may be inspected. An electron-optical device 40 may comprise either a single beam or a multi-beam electron-optical apparatus.

The controller 50 is electronically connected to the electron-optical device 40. The controller 50 may be a processor (such as a computer) configured to control the charged particle beam inspection apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it may be distributed over at least two of the component elements. While the present disclosure provides examples of main chamber 10 housing an electron beam inspection apparatus, it should be noted that aspects of the disclosure in their broadest sense are not limited to a chamber housing an electron-optical device. Rather, it is appreciated that the foregoing principles may also be applied to other apparatuses and other arrangements of apparatus that operate under the second pressure.

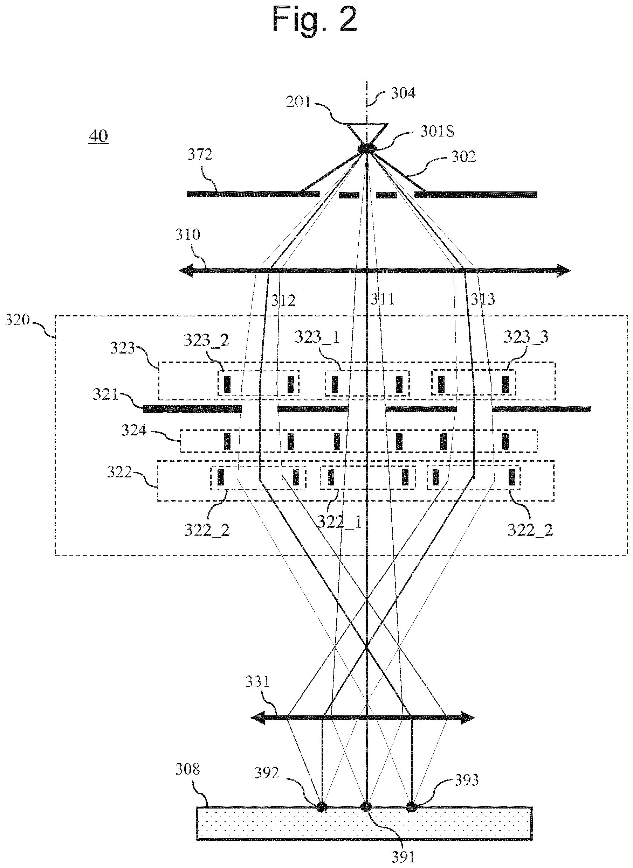

Reference is now made to Figure 2, which is a schematic diagram of an exemplary multi-beam electron-optical device 40 of an assessment apparatus, e.g. the inspection apparatus 100 of Figure 1. In an alternative embodiment the inspection apparatus 100 is a single-beam assessment apparatus. The electron-optical device 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. (In a single beam assessment apparatus may have the same features as a multibeam assessment apparatus except electron-optical components with an array apertures 372, 320 may have a single aperture. The source converter 320 may be replaced with a number of electron-optical components along the beam path.) The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical device 40. The source converter 320 (also known as a source conversion unit), described in more detail below, and the objective lens 331 may be the components of a projection apparatus comprised by the electron-optical device 40.

The electron source 201, the beam former array 372, the condenser lens 310, the source converter 320, and the objective lens 331 are aligned with a primary electron-optical axis 304 of the electron-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical device 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate inspection resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may further comprise a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of on beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical device 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be down-beam of the source converter 320. The beam separator may be, for example, a Wien filter comprising an electrostatic dipole field and a magnetic dipole field. The beam separator may be upbeam of the objective lens 331. The beam separator may be positioned between adjacent sections of shielding (described in more detail below) in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such Wien filter, a secondary device and/or a secondary projection apparatus may be provided in a single beam assessment apparatus. Additionally and/or alternatively a detection device may be present down beam of the objective lens, for example facing the sample during operation. In an alternative arrangement a detector device is position along the path of the charged particle beam towards the sample. In such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electro-static plates may be arranged in series of two or more adjoining plates along the path of the charged particle beam.

In an embodiment the inspection apparatus 100 comprises a single source.

Any element or collection of elements may be replaceable or field replaceable within the electron-optical device. The one or more electron-optical components in the electron-optical device, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical device 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

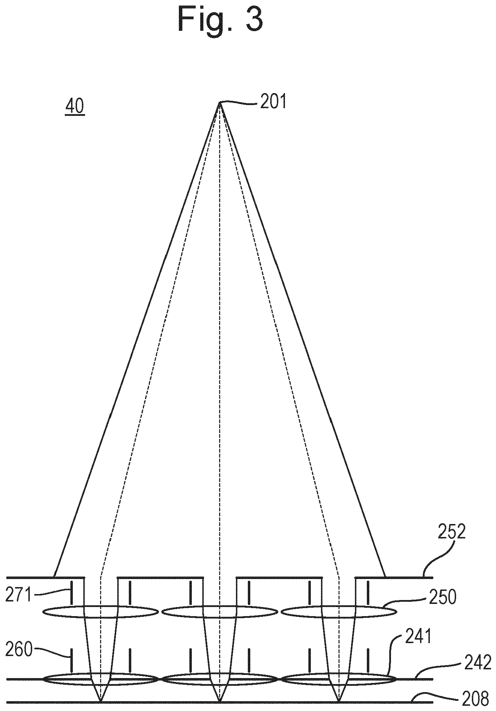

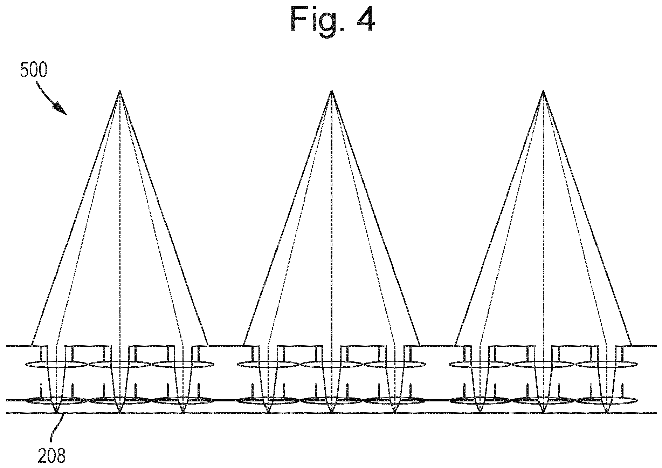

In an embodiment the electron-optical device 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical device 40 that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The detector may comprise an array, for example of detector elements, which may correspond to the array of the beamlets of the multi-beam arrangement. The detectors (or detector elements) in the detector array may generate detection signals that may be associated with the pixels of a generated image. The condenser lenses, objective lenses and/or detector may be formed as MEMS or CMOS devices.

Figure 3 is a schematic diagram of another design of an exemplary electron-optical device 40. The electron-optical device 40 may comprise a source 201 and one or more electron-optical assemblies. Alternatively, the electron-optical apparatus that comprises the electron-optical device 40 may comprise the source 201. The electron-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens for example in terms of providing one more extra degrees of freedom to the objective lens. Although the control lens array 241 may be indistinct from and part of the objective lens array 250, in this description the control lens array 250 is considered to be distinct and separate from the objective lens array 241.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of a two electrode lens over an Einzel lens is that the energy of an incoming beam is not necessarily the same as an outgoing beam. Beneficially the potential differences on such a two electrode lens array enables it to function as either an accelerating or a decelerating lens array.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. The apertures of the beam shaping limiter 242 may have a smaller diameter than the apertures of at least one of the objective lens array 241, the control lens array 250, the detector array 240 and the upper beam limiter array 252. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical device 40 is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. Note, the most downbeam electrode of the control lens array 250 may be the most up-beam electrode of the objective lens array 241. That is the control lens array 250 and the objective lens array 241 may share an electrode. The shared electrode provides different lensing effects for each lens, each lensing effect with respect one its two opposing surfaces (i.e. up beam surface and down beam surface). The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles (e.g. signal particles) detected by a scanning electron microscope, including secondary (e.g. emitted) and/or backscattered electrons from the sample 208. The detector may be an array providing the surface of the electron-optical device facing the sample 208, e.g. the bottom surface of the electron-optical device. Alternative the detector array be up beam of the bottom surface or example in or up beam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical device array 500 is provided. The array 500 may comprise a plurality of any of the electron-optical devices described herein. Each of the electron-optical devices focuses respective multi-beams simultaneously onto different regions of the same sample. Each electron-optical device may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical devices in the array 500 may be arranged adjacent to each other so as to project the respective multi-beams onto adjacent regions of the sample 208.

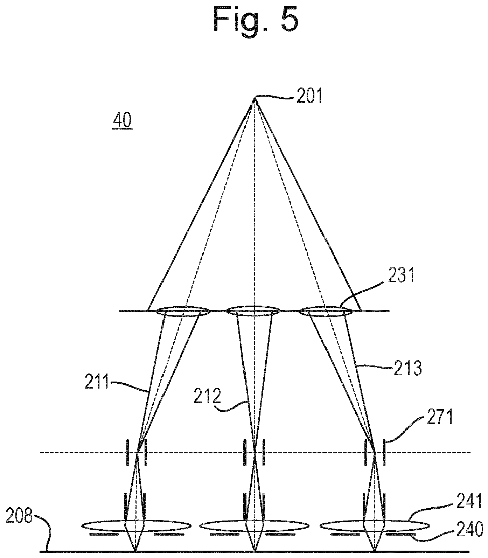

Any number of electron-optical devices may be used in the array 500. Preferably, the number of electron-optical devices is in the range of from two (2), desirably nine (9) to one hundred (100) even two hundred (200). In an embodiment, the electron-optical devices are arranged in a rectangular array or in a hexagonal array. In other embodiments, the electron-optical devices are provided in an irregular array or in a regular array having a geometry other than rectangular or hexagonal. Each electron-optical device in the array 500 may be configured in any of the ways described herein when referring to a single electron-optical device, for example as described above, especially with respect to the embodiment shown and described in reference to Figure 5. Details of such an arrangement is described in EPA 20184161.6 filed 6 July 2020 which, with respect to how the objective lens is incorporated and adapted for use in the multi-device arrangement is hereby incorporated by reference.

In the example of Figure 4 the array 500 comprises a plurality of electron-optical devices of the type described above with reference to Figure 3. Each of the electron-optical devices in this example thus comprise both a scan-deflector array 260 and a collimator element array 271. As mentioned above, the scan-deflector array 260 and collimator element array 271 are particularly well suited to incorporation into an electron-optical device array 500 because of their spatial compactness, which facilitates positioning of the electron-optical devices close to each other. This arrangement of electron-optical device may be preferred over other arrangements that use a magnetic lens as collimator. Magnetic lenses may be challenging to incorporate into an electron-optical device intended for use in a multi-device arrangement (e.g. multi-column arrangement) for example because of magnetic interference between columns.

An alternative design of multi-beam electron-optical device may have the same features as described with respect to Figure 3 expect as described below and illustrated in Figure 5. The alternative design of multi-beam electron-optical device may comprise a condenser lens array 231 upbeam of the object lens array arrangement 241, as disclosed in EP application 20158804.3 filed on 21 February 2020 which is hereby incorporated by reference so far as the description of the multi-beam device with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens 241. The detector 240 may be on the bottom surface of the objective lens 241 so as to face a sample in use.

In an embodiment of the arrangement shown in and described with reference to Figure 5, the detector may be located in similar locations in the electron-optical device 40 as described with reference to and as shown in the electron-optical device of Figure 3. The detector 240 may be integrated into the objective lens array 241 and the control lens array 250 (when present as it is not depicted in Figure 5). The detector may have more than one detector at different positions along the paths of the sub-beams of the multibeam, for example each array associated with a different electron-optical element, such as an electrode of the objective lens array and/or the control lens array. The objective lens array 241 and associated electron-optical elements such as the control lens array 250 may be comprised in assembly which may be a monolithic assembly which may be referred to as an electron-optical assembly or an electron-optical module 41. In an embodiment a detector 240 is associated with, or even integrated into, a planar element of the electron-optical module 41. For example, the detector 240 may be on the bottom surface of an electron-optical module 41 comprising objective lenses 241. The detector 240 may be provided with an electric connection 60 as described elsewhere in this document. In a variation, the detector has a detector array positioned up beam of the objective lens array (optionally and the control lens array 250) for example upbeam of the electron-optical module 41. Between the electron-optical module 41 and the detector array may be a Wien filter array that directs the charged particles beams in a downbeam direction towards the sample and directs signal particles from the sample to the detector array.

An electron-optical device array may have multiple multi-beam devices of this design as described with reference to the multi-beam device of Figure 3 as shown in Figure 4. The multiple multi-beam devices may be arranged in an array of multi-beam devices. Such an arrangement is shown and described in EP Application 20158732.6 filed on 21 February 2020 which is hereby incorporated by reference with respect to the multi-device arrangement of a multi-beam apparatus featuring the design of multi-beam device disclosed with a collimator at an intermediate focus. A further alternative design of multi-beam apparatus comprises multiple single beam devices. The single beams generated for the purposes of the invention herein described may be similar or equivalent to a multi-beam generated by a single device. Each device may have an associated detector. Such a multi-device apparatus may be arranged in an array of devices of three, four, nine, nineteen, fifty, one hundred or even two hundred devices each generating a single beam or beamlet (if of a single beam device) or a plurality of beams (if of multibeam devices). In this further alternative design the array of devices may have a common vacuum system, each device have a separate vacuum system or groups of devices are assigned different vacuum systems.

The electron-optical device 40 may be a component of an inspection (or assessment metro-inspection) apparatus or part of an e-beam lithography apparatus. The multi-beam charged particle apparatus may be used in a number of different applications that include electron microscopy in general, not just scanning electron microscopy, and lithography.

The electron-optical axis 304 describes the path of charged particles through and output from the source 201. The sub-beams and beamlets of a multi-beam may all be substantially parallel to the electron-optical axis 304 at least through the manipulators or electron -optical arrays, for example of the arrangement shown and described with reference to Figure 2, unless explicitly mentioned. The electron-optical axis 304 may be the same as, or different from, a mechanical axis of the electron-optical device 40. In context of the arrangement shown and described with respect to Figures 2 to 5, the electron-optical axis may correspond to the path of the central beam of the multibeam, for example beam 212. The beams of the multibeam are substantially parallel to each other (for example along the electron-optical axis 304) between collimation (e.g. the location of the collimator array 271 which correspond to a plane of intermediate foci (for example as shown in Figure 5) or an upper beam limiter 252) and the surface of the sample 208.

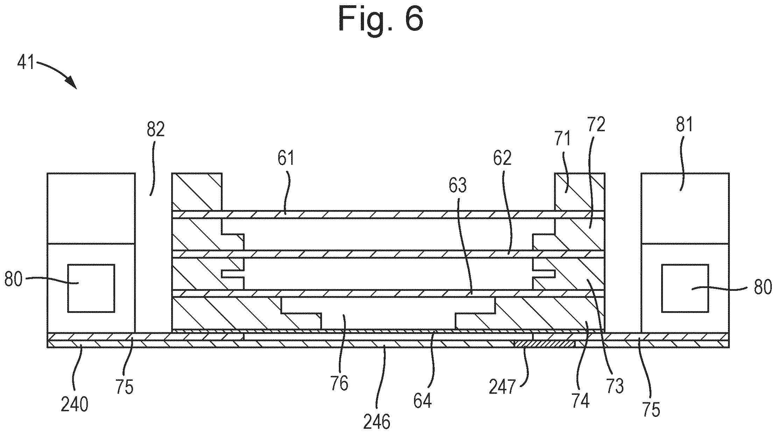

The electron-optical device 40 may comprise an electron-optical module 41 as shown in Figure 6 for manipulating electron beamlets. For example, the electron-optical module 41 may comprise one or more of (in a non-limited list): the objective lens array 241, and/or the condenser lens array 231 and/or the collimator element array 271 and/or an individual beam corrector and/or a deflector and/or a Wien filter array. In particular, the objective lens 331 and/or the condenser lens 310 and/or the control lens 250 may comprise the electron-optical module 41.

The electron-optical module 41 is configured to provide a potential difference between two or more plates (or substrates). An electrostatic field is generated between the plates, which act as electrodes. The electrostatic field results in an attraction force between the two plates. The attraction force may be increased with increasing potential difference.

Figure 6 is a schematic view of an electron-optical module 41. The electron-optical module 41 is for directing electrons along a beam path towards a sample location. In the orientation shown in representative, schematic Figure 6, the beam path is down the middle of the drawing from top to bottom.

As shown in Figure 6, in an embodiment the electron-optical module 41 comprises a plurality of planar elements 61-64. The planar elements 61-64 are arranged across the beam path. In an embodiment the beam path is substantially perpendicular to the planes of the planar elements 61-64. The planar elements 61-64 are configured to operate on the electrons, i.e. the electrons that are directed along the beam path. For example, one or more of the planar elements 61-64 may be an electron-optical element such as an electron-optical lens element or an electron-optical deflector element. In an embodiment, one or more of the planar elements 61-64 is a planar element other than an electron-optical element. For example, in an embodiment, one or more of the planar elements 61-64 is configured to operate on the electrons without requiring an applied voltage. For example, one or more of the planar elements 61-64 may be configured to limit one or more beams of electrons by blocking some of the electrons. Although the term 'planar elements' incorporates the word 'planar', that the planar elements are planar is an embodiment. In another embodiment, one or more of the planar elements may be any suitable electron-optical element for example an electrostatic element capable of interacting or operating on the electrons along the beam path, such as an electrode and/or a plate. In an embodiment the planar elements are thermally conductive. The planar elements may conduct heat away from the beam path.

As shown in Figure 6, in an embodiment, the planar elements 61-64 are stacked relative to each other. The planar elements 61-64, 240 may be comprised in a stack. As shown in Figure 6, one of the planar elements may be or comprise a detector 240. The detector 240 may be configured to detect signal electrons from the sample location. The detector 240 may comprise one or more detector elements configured to detect electrons for example in a detector array. Additionally or alternatively the stack may comprise one or more detectors that are monitoring detectors to detect one more primary beams during operation and/or calibration of the electron-optical device

In an embodiment two or more of the planar elements 61-64 are configured to function as one or more electron-optical lenses when a potential difference is applied between them. For example, the planar elements 61-64 may constitute an array of objective lenses 241 and/or an array of control lenses 250. In an embodiment the electron-optical module 41 is an objective lens assembly. Additionally or alternatively, the electron-optical module 41 may comprise a condenser lens array and/or a deflector array and/or an array of individual beam correctors and/or an array of beam limiting apertures. In an embodiment one or more of the planar elements 61-64 comprises a single aperture for the passage therethrough of a plurality of, optionally all of, the beam paths. Such a planar element may be referred to as a macro plate.

As shown in Figure 6, in an embodiment the electron-optical module 41 comprises a thermal conditioning channel 80. The thermal conditioning channel 80 is spaced from the planer elements 61-64 in a direction through the planar element 61-64. For example, when the electron-optical module 41 is viewed in a direction parallel to the beam path (i.e. perpendicular to the planes of the planar element 61-64), the thermal conditioning channel 80 is spaced from the planar elements 61-64. As shown in Figure 6, there may be a space or gap 82 between the planar elements 61-64 and the thermal conditioning channel 80. It is not essential for the thermal conditioning channel 80 to be spaced from the planar elements 61-64. In an alternative embodiment the thermal conditioning channel 80 is in contact with one or more of the planar elements 61-64. For example, when the thermal conditioning channel is made of an electrically insulating material (or an electrically non-conductive material), then the gap 82 may be omitted.

In an embodiment, the thermal conditioning channel is configured to thermally condition the electron-optical module 41. In an embodiment the thermal conditional channel 80 is configured to contain thermal conditioning fluid for thermally conditioning the electron-optical module 41. The thermal conditioning fluid may be a liquid such as water, or a gas. In an embodiment a fluid supplier is configured to supply thermal conditional fluid to the thermal conditioning channel 80. The thermal conditioning fluid flows through the thermal conditioning channel 80. Heat may be exchanged between the thermal conditional fluid in the thermal conditioning channel 80 and the components of the electron-optical module 41. For example, the thermal conditioning fluid may heat up and carry heat away from the planar elements 61-64. The thermal conditioning channel 80 is configured to modulate, e.g. control, the temperature of components of the electron-optical module 41 such as the planar elements 61-64.

During use of the electron-optical module 41, the planar elements 61-64 may receive incident energy from the beam of electrons. This may cause the planar element 61-64 to heat up. The thermal conditioning channel 80 may at least partly counteract the heating of the electron-optical module 41 caused by the incident electron beams.

As shown in Figure 6, in an embodiment the electron-optical module comprises a plurality of thermal conditioning channels 80. For example, as shown in Figure 6, in an embodiment thermal conditioning channels 80 are located on opposite sides of the one or more electron beams. When there are multiple electron beams, the beam paths of the electron beams may be arranged in a pattern which may be referred to as a beam grid. In an embodiment, the beam grid is located between thermal conditioning channels 80. Although only two thermal conditioning channels 80 are shown in Figure 6, in an embodiment the electron-optical module 41 comprises three, four or more than four thermal conditioning channels 80. In an embodiment, the thermal conditional channels 80 are arranged on different sides of the electron-optical module 41 when viewed in a direction parallel to the beam path. In an embodiment the thermal conditioning channels 80 are in fluid communication with each other. Thermal conditioning fluid that flows through one of the thermal conditioning channels 80 may continue through a network of channels so as to flow through one or more other of the thermal conditioning channels 80. Alternatively, the thermal conditioning channels 80 may be independent of each other.

The thermal conditioning channels 80 may be connected in parallel and/or in series. In an embodiment the thermal conditioning channels 80 extend around the electron-optical module 41. For example, the one or more conditioning channels 80 may extend around the electron-optical module 41 more than once, for example, multiple times. The thermal conditioning channels 80 may extend helically.

In an embodiment one or more thermal conditioning channels 80 extends around one side of the planar elements 61-64. In an embodiment one or more thermal conditioning channels 80 extends all the way round (e.g. surrounds when viewed in plan) the planar elements 61-64.

In an embodiment one or more thermal conditioning channels 80 is connected to a planar element that has another planar element downbeam of it. For example, in an embodiment one or more thermal conditioning channels 80 is connected to a detector 240 that is located midway in the stack (i.e. the detector 240 is located between other planar elements of the stack). In an embodiment one or more thermal conditioning channels 80 is connected to a detector 240 that is located at an upbeam end of the electron-optical module 41.

As shown in Figure 6, in an embodiment the thermal conditioning channel 80 has a square cross-section. However, it is not essential for the cross-section to be square. In an embodiment the thermal conditioning channel 80 has a cross-section comprising a curve, for example a circle or an oval. A curved inner surface of the channel may be more fluid-dynamically favorable.

As shown in Figure 6, in an embodiment the thermal conditioning channels 80 are positioned to the side of the region through which the electron beams pass. The electron beams may be arranged in a relatively dense beam grid. The thermal conditioning channels 80 are located external to the beam grid. The electron beams may be arranged in a relatively narrow region undisturbed by the thermal conditioning channels 80. The thermal conditioning channels 80 being located to the outside of the electron-optical module 41 allow the region within the sample location that can be reached by the electron beams to be more continuous (i.e. with fewer gaps between electron beams at the sample location).

In an embodiment, the electron-optical module 41 comprises a thermally conductive plate. The thermally conductive plate is connected to the thermal conditioning channel 80. The thermally conductive plate is for transferring heat towards the thermal conditioning channel 80. In an embodiment the thermal conductive plate is or comprises one of the planar elements such as the detector 240. In an embodiment the thermal conductive plate is or comprises the detector 240. Additionally or alternatively, in an embodiment, the thermally conductive plate is or comprises a spacer such as the detector spacer 75 shown in Figure 6. The detector spacer 75 is configured to space the detector 240 from one or more of the planar elements 61-64. For example, in an embodiment the most downbeam planar element 64 that is upbeam of the detector 240 may constitute an electrode of an array of objective lenses 241. The detector spacer 75 is configured to space the detector 240 from the objective lenses 241. The detector spacer 75 may be thicker (in a direction parallel to the beam path) than the most downbeam electrode of the objective lenses 241. As shown in Figure 6 there may be a narrow gap between the most downbeam planar element 64 of the objective lenses 241 and the detector 240 for example in the direction of the beam path. That is the detector spacer may have a dimension in the beam path smaller than other spacers 71, 72, 73, 74 of the stack. The invention will be described below in the context of the detector 240 being the thermally conductive plate. However, the invention may be embodied with the detector spacer 75 (or another spacer) being the thermally conductive plate. In an embodiment the thermally conductive plate comprises both the detector 240 and a spacer such as the detector spacer 75.

As shown in Figure 6, in an embodiment the thermally conductive plate is connected to the downbeam end of the thermal conditioning channel 80. However, this is not an essential feature. In an embodiment a substrate such as the thermally conductive plate is connected to the upbeam end of the thermal conditioning channel 80. In an embodiment substrates (e.g. thermally conductive plates) are connected to both the upbeam end and the downbeam end of the thermal conditioning channel 80. In an embodiment a thermally conductive plate such as the detector 75 is connected to a surface of the thermal conditioning channel 80 facing towards the beam area. For example, the detector spacer 75 may comprise an outer peripheral edge in contact with the thermal conditioning channel 80. The thermal conditioning channel 80 may be directly connected to the detector 240.

As shown in Figure 6, in an embodiment the detector 240 (i.e. the thermally conductive plate) extends between the planar elements 61-64 and the thermal conditioning channel 80 in a direction parallel to one or more of the planar elements 61-64. When the electron-optical module 41 is viewed in a direction through the planar element 61-64, the detector 240 (i.e. the thermally conductive plate) extends between the planar element 61-64 and the thermal conditioning channels 80. The gap 82 overlaps the detector 240. In an embodiment the detector 240 overlaps the thermal conditioning channel 80 when viewed in a direction parallel to the beam path. In an embodiment the detector 240 overlaps the planar elements 61-64 when the electron-optical module 41 is viewed in a direction parallel to the beam path.

An embodiment of the invention is expected to improve moderation of the temperature of the electron-optical module 41. The thermally conductive plate helps to conduct heat towards the thermal conditioning channel 80. The thermal conditioning channel 80 is configured to function as a heat sink. By providing that the thermally conductive plate extends between the planar elements 61-64 and the thermal conditioning channel 80, conductance of heat from the planar elements 61-64 to the thermal conditioning channel 80 may be improved.

As mentioned above, in an embodiment the thermally conductive plate is a planar element such as a detector 240 for detecting signal particles from the sample location. In an embodiment the detector 240 is a detector array comprising an array of detectors configured to detect signal particles from the sample location. Alternatively, in an embodiment the thermally conductive plate is connected to a planar element such as a detector 240. For example, the thermally conductive plate may be the detector spacer 75, which is connected to the detector 240.

In an embodiment the detector 240 has a thickness in a direction parallel to the beam path greater than or essentially equal to a thickness of one or more of the planar elements 61-64. In an embodiment the detector 240 has a thickness greater than or substantially equal to a thickness of all of the other planar elements 61-64. By increasing the thickness of the substrate of the detector 240, conductance of heat through the detector 240 towards the thermal conditioning channel 80 may be increased. This can help to moderate the temperature of the planar element 61-64. In an embodiment the substrate of the detector 240 has a thickness of at least 100µm, optionally at least 200µm, and optionally at least 300µm. Increasing the thickness of the detector 240 can help to reduce the temperature of the detector 240. Limiting the temperature of the detector 240 can help to limit the heat load (e.g. radiative load) the detector 240 may apply to upbeam electron-optical elements and/or the downbeam sample 208. In an embodiment the substrate of the detector 240 has a thickness of at most 500µm, and optionally at most 300µm. In an embodiment a planar element 61-64 has a thickness of at least 50µm, and optionally at least 100µm. In an embodiment a planar element 61-64 has a thickness of at most 2000µm, optionally at most 150µm, and optionally at most 100µm. In an embodiment the thermally conductive plate has a thickness of at least 100µm, optionally at least 200µm, and optionally at least 300µm.

In an embodiment the detector 240 is configured to conduct heat generated in the detector 240 during operation towards the thermal conditioning channel 80. For example, in an embodiment the thermally conductive plate (e.g. the detector 240) comprises, or is connected to a component that comprises, active electronics such as a CMOS device, which may operate at a lower operating potential, for example -10V. Such active electronics may increase the amount of heat that is generated in the electron-optical module 41 during use the electron-optical module 41, for example despite the low operating potential. For example, voltages may be applied to the active electronics. The application of voltages may result in heat being dissipated in the thermally conductive plate (e.g. the detector 240) because, for example, the thermally conductive plate is within a vacuum.

For example, in an embodiment one or more electron beams are incident on a central region 246 of the detector 240. The incident electron beams may heat the detector 240. Additionally, detector elements within central region 246 of the detector 240 may comprise active electronics such as one or more CMOS devices. The active electronics may increase heat generated in the detector 240. Additionally or alternatively, the detector may comprise other active electronics in a peripheral region 247 of the detector 240. The peripheral region 247 may be located external to the region through which the electron beams pass. In an embodiment the peripheral region 247 of the detector 240 comprises active electronic components such as analog-to-digital converters (ADCs). The ADCs may generate heat at the detector 240. In an embodiment the thermally conductive plate is configured to conduct heat generated in the central region 246 and/or in the peripheral region 247 towards the thermal conditioning channel 80.

In an embodiment the thickness of the detector 240 is dimensioned sufficient to conduct the heat generated in the detector 240 during operation towards the thermal conditioning channel 80. In an embodiment the detector 240 comprises a material having a thermal conductivity sufficient to conduct the heat generated in the detector 240 during operation towards the thermal conditioning channel 80. In an embodiment the material of the thermal conditioning channel 80 has a thermal conductivity in the range of from about 15W/mK to about 20W/mK. In an embodiment the thermally conductive plate has a thermal conductivity in the range of from about 50W/mK to about 100W/mK. An embodiment of the invention is expected to reduce an operating temperature of the detector 240.

As shown in Figure 6, in an embodiment heat generating circuitry such as the ADCs may be located in a peripheral region 247. By locating the circuitry as close as possible to the thermal conditioning channel 80, conductance of the heat generated towards the thermal conditioning channel 80 may be improved. In an embodiment heat generating circuitry is comprised in one or more planar elements 61-64 other than the detector 240. For example, a planar element that is an array of individual beam correctors, a deflector array or a corrector array may comprise heat generating circuitry.

In the arrangement shown in Figure 6, the peripheral region 247 in which the heat generating circuitry such as ADCs is located is provided at only one side of the electron-optical module 41. In an alternative arrangement, the circuitry may be located symmetrically. For example, the heat generating circuitry may be located in peripheral regions on either side of the electron beam.

During use of the electron-optical module 41, the main origin of thermal energy may be expected to be the detector 240, particularly the beam area in the central region 246 and the circuitry in the peripheral region 247. An embodiment of the invention is expected to improve dissipation of thermal energy through the thermal conditioning channel 80 as a heat sink. The thermal conditioning channel 80 is configured to actively cool the electron-optical module 41. Active cooling is expected to increase heat removal capacity compared to passive cooling. The thermal conditioning channels 80 at the side of the electron-optical module 41 allow the beam area to remain large. In particular, the individual electron beams of a multi-beam are not separated by thermal conditioning channels. By spacing the thermal conditioning channel 80 from the planar elements 61-64, the possibility of electrical creep and/or electrical breakdown between the planar elements 61-64 and the thermal conditioning channel 80 may be reduced.

As shown in Figure 6, in an embodiment the electron-optical module 41 comprises spacers 71-75. The spacers 71-75 are configured to space the planar elements 61-64 and the detector 240 from each other. In an embodiment the spacers 71-75 are configured to mechanically support the planar elements 61-64. In an embodiment the spacers 71-75 are configured to electrically isolate planar elements 61-64 from each other. However, it is not essential for the spacers 71-75 to provide electrical isolation. For example, two adjoining planar elements may be operated at the same voltage, in which case it may not be necessary for them to be electrically isolated from each other.

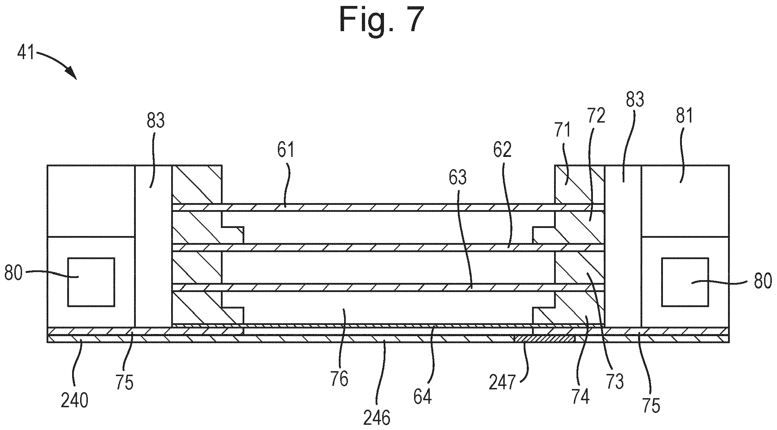

Figure 7 is a schematic view of an electron-optical module 41 according to an embodiment of the invention. Features of the electron-optical module 41 that are the same as described in relation to the electron-optical module 41 shown in Figure 6 are not described in detail below. This is to avoid repetition of description. The features shown in Figure 7 may have the same characteristics as those of the similarly labelled features shown in Figure 6.

As shown in Figure 7, in an embodiment the gap 82 between the planar elements 61-64 and the thermal conditioning channel 80 may be filled with a material. In an embodiment the electron-optical module 41 comprises a material 83 electrically isolating the planar elements 61-64 from the thermal conditioning channel 80. For example, the material 83 may be potting material. In an embodiment the material 83 is provided to reduce the possibility of high voltage electrical discharges.

An embodiment of the invention is expected to improve thermal conductance of heat energy from an electrostatic lens stack (e.g. formed by the planar elements 61-64 towards the thermal conditioning channel 80. By providing the material 83, the thermal conditioning channel 80 may be located closer to the planar elements 61-64 without unduly increasing the risk of electrical breakdown between the planar elements 61-64 and the thermal conditioning channel 80. In an embodiment the thermal conditioning channel 80 comprises an electrically conductive material such as a metal. Such an electrically conductive material may be mechanically stiff. The material 83 allows the active cooling provided by the thermal conditioning channel 80 to be nearer the stack, i.e. nearer the planar elements 61-64. In an alternative embodiment the thermal conditioning channel 80 is electrically insulating. For example, the thermal conditioning channel 80 may comprise (e.g. be formed of) an electrically insulating material such as a ceramic. The ceramic may be sintered to form the channel. The sintered ceramic may be milled to reduce any errors in shape of the ceramic following the sintering process. In embodiment, such a process to manufacture the thermal conditioning channel 80 may be less desirable than other techniques, such as three dimensional printing, because of the dimensional instability induced in a structure during sintering.

An embodiment of the invention is expected to increase the effectiveness of cooling the stack from incident electron beam power and from power dissipated by electronics for example in the detector 240. By decreasing the distance between the heat sources and the heat sink (i.e. the thermal conditioning channel 80), the cooling may be made more effective. By providing the electrically isolating material 83, the risk of electric discharges can be prevented from increasing. For example, in an embodiment parts of the electron-optical module 41 may be operated at high voltage. For example, high voltage is maybe applied to one or more of the planar elements 61-64. In contrast, the thermal conditioning channel 80 and/or the thermal conditioning fluid within the thermal conditioning channel 80 may be at a reference ground potential for the electron-optical module 41.

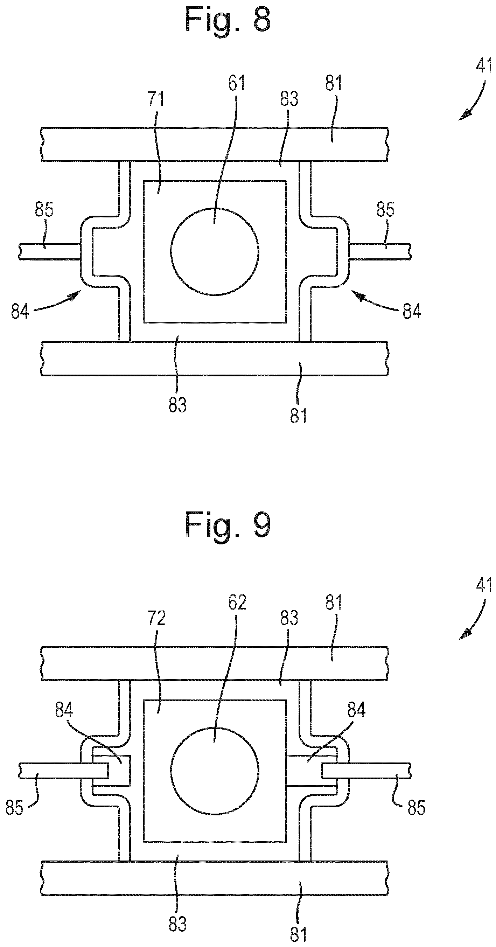

Figure 8 is a schematic plan view of the electron-optical module 41 shown in Figure 7. As shown in Figure 8, in an embodiment the material 83 surrounds one or more of the planar elements 61-64. For example, the material 83 may surround the planar element 61 when viewed in a direction parallel to the beam path. The material 83 may surround one or more of the planar elements 61-64 in a plane of the planar elements 61-64.

In Figure 8, the most upbeam planar element 61 is shown. This is because the view of Figure 8 is from an upbeam side of the electron-optical module 41. Figure 8 shows the material 83 surrounding the most upbeam planar element 61 in the plane of the most upbeam planar element 61. In an embodiment the material 83 similarly surrounds the other planar elements 62-64. The material 83 is configured to reduce the possibility of electrical breakdown between the planar elements 61-64 and the thermal conditioning channel 80. The material 83 is configured to electrically insulate the planar elements 61-64 from each other. The material 83 is configured to decrease the possibility of electrical breakdown between the planar elements 61-64. The material 83 lengthens the creep path between the planar elements 61-64. In an embodiment the outward facing surfaces of planar elements 61-64 are covered with the material 83. By covering the outward facing surfaces of the planar elements 61-64, the creep path between the planar elements 61-64 may be lengthened.

In an embodiment the material 83 continuously fills a volume between one or more planar elements 61-64 and the thermal conditioning channel 80. Continuous filling of the material 83 means that there are substantially no gaps or pockets that are not filled by the material 83. In particular, there is no path from the planar elements 61-64 to the thermal conditioning channel 80 that does not pass through the material 83. That is any path, such a virtual straight line, between the planar elements 61-64 and the thermal conditioning channel passes through the material 83. The material 83 separates the thermal conditioning channel 80 from the planar elements 61-64. In an embodiment the material 83 completely fills the volume between the planar elements 61-64 and the thermal conditioning channel 80. Figure 8 shows the material 83 filling the volume between the most upbeam planar elements 61 and the thermal conditioning channel 80. In an embodiment the material 83 similarly continuously fills, desirably completely fills, a volume between all of the planar elements 61-64 and the thermal conditioning channel 80. Alternatively, the material 83 may fill a volume between a subset of the planar elements 61-64 and the thermal conditioning channel 80. In an embodiment one or more of the planar elements 61-64 is configured to be operated at a similar voltage to the thermal conditioning channel 80 (e.g. ground potential) such that it is not necessary to provide the material 83 between that planar element and the thermal conditioning channel 80. In an arrangement in which the thermally conductive plate is located in the midst of the stack or there are multiple thermally conductive plates within the stack, there may be multiple volumes between the planar elements 61-64 and the thermal conditioning channel. One or more of the multiple volumes may be filled with the material 83. The filling of the multiple volumes may be similar to as described for one volume (e.g. the gap 82) described herein.

In an embodiment the volume that is filled by the material 83 has a surface defined by a portion of a surface of the thermally conductive plate (e.g. the detector 240 or the detector spacer 75). The surface of the thermally conductive plate may be parallel to the one or more planar elements 61-64. For example, in the arrangement shown in Figure 7, the volume filled by the material 83 is defined by a portion of the upbeam surface of the spacer 74 that is located between the planar elements 63, 64. The spacer 74 may form the thermally conductive plate. The spacer 74 may comprise the same material as the other spacers 71. The detector spacer 75 may extend laterally away from the location of the beam of electrons through the module 41 than other spacers 71-73, although this need not be the case. This may be desirable to assist conductance of thermal load away from the detector limiting the conductance of heat to the stack. The detector spacer 75 may extend laterally inwardly to a similar position as others of the spacers 71, 72, 73, 74 in the stack,. The spacer may extend laterally so far that it contacts the thermal conditioning channel 80, for example in contact with a downward or upward facing surface of the thermal conditioning channel 80.

In an embodiment the volume that is filled by the material 83 is defined by a surface of the thermal conditioning channel 80. The surface of the thermal conditioning channel 80 may face one or more of the planar elements 61-64. For example, as shown in Figure 7, in an embodiment the thermal conditioning channel 80 has an upbeam facing surface, a downbeam facing surface, an outward facing surface and an inward facing surface. The inward facing surface faces the planar elements 62, 63. The inward facing surface of the thermal conditioning channel 80 defines the volume filled by the material 83.

In an embodiment the volume that is filled by the material 83 is defined by an outer surface of one or more planar elements 61-64. For example, as shown in Figure 6, in an embodiment the outer surfaces of the planar elements 61, 62, 63 define the volume that is filled by the material 83. In an embodiment the planar elements 61-64 comprise one or more apertures defined in them. The apertures may be provided for the passage there through of one or more electron beams. The apertures are in the region in which the electron beams pass, i.e. the central part of the planar elements 61-64. The outer surface of the planar elements 61-64 may be defined relative to the apertures defined in the planar elements 61-64. The outer surfaces face away from the apertures.

As shown in Figure 7, in an embodiment the volume that is filled by the material 83 is defined by one or more spacers 71-74. For example, in the arrangement shown in Figure 7, the volume is defined by spacers 72, 73 between adjoining planar elements 61-63. More particularly, the volume is defined by the outer surface of the spacers 72, 73 between adjoining planar elements 61-63. In an embodiment the volume is defined by one or more spacers 74 between an individual planar element 63 and the thermally conductive plate. For example, the upbeam surface of the spacer 74 that is between the planar element 63 and the thermally conductive plate defines the volume. In an embodiment the volume that is filled by the material 83 is defined by one or more spacers 71 upbeam of the planar elements 61-64. For example, as shown in Figure 7, the outer surface of the most upbeam spacer 71, which is upbeam of the most upbeam planar element 61 of the electron-optical module 41 defines the volume that is filled by the material 83. In an embodiment the material 83 comprises a glass such as a borosilicate glass. In an embodiment the material 83 comprises the same substance as one or more of the spacers 71-75.

During use of the electron-optical module, one or more of the planar elements 61-64 may have a voltage applied to them. In an embodiment, one or more of the planar elements 61-64 is connected to a high voltage power supply. High voltage refers to a voltage of at least 2kV, optionally at least 5kV, optionally at least 10kV and optionally at least 20kV relative to a reference ground potential. A planar element may be connected to a high voltage power supply via an electrical cable and an electrical connector. For example, Figure 8 schematically shows two electrical cables 85 and two electrical connectors 84. Each electrical cable 85 and electrical connector 84 may correspond to a respective planar element. The electron-optical device, or at least the electron-optical apparatus, may comprise one or more voltage supplies to supply the respective potential differences to components of the stack, for example one or more of the planar elements of the stack.

Figure 9 is a schematic view of the electron-optical module 41 shown in Figure 8 but with the most upbeam spacer 71 and the most upbeam planar element 61 removed. In the view shown in Figure 9, some of the potting material 83 that surrounds the most upbeam spacer 71 and the most upbeam planar element 61 has been removed. As a result, Figure 9 shows the next most upbeam spacer 72 and the next most upbeam planar element 62. The electrical connectors 84 are more visible in Figure 9. In other words Figure 9 may be considered to be a cross-section through the electron-optical module 41 of Figure 8 at the next most upbeam spacer 72.

In the arrangement shown in Figure 9, the electrical connector 84 shown on the right-hand side of the drawing may be connected to the planar element 62 shown in the Figure. The electrical connector 84 is configured to electrically connect the planar element 62 to the electrical cable 85 on the right-hand side of the drawing. The electrical connector 84 and the electrical cable 85 are configured to electrically connect the planar element 62 to a high voltage power supply. The electrical connector 84 and the electrical cable 85 shown on the left-hand side of the drawing may be configured to connect another of the planar elements (for example planar element 63) to a high voltage power supply.

Although two electrical connectors 84 and respective electrical cables 85 are shown in Figures 8 and 9, in an embodiment the electron-optical module 41 comprises one electrical connector 84 with an associated electrical cable 85, or three or more electrical connectors with associated with electrical cables. In an embodiment a different electrical connector and cable is provided for each planar element. Alternatively, two or more of the planar elements may be connected to the same electrical cable and power supply.

In the view shown in Figure 8, the upbeam surfaces of the electrical connectors 84 are covered by the material 83. As shown in Figure 8, for example, in an embodiment the material 83 electrically isolates the thermal conditioning channel 80 from one or more electrical connectors 84. The material 83 reduces the possibility of electrical breakdown between the electrical connector 84 (which may comprise electrically conductive material such as metal) and the thermal conditioning channel 80. In an embodiment the materials 83 reduces the possibility of electrical breakdown between the electrical connectors 84 and the planar elements 61-64.

The material 83 is an electrically insulating material. In an embodiment the material 83 is also thermally conductive. When the material 83 is more thermally conductive, then the material 83 can contribute to increasing flow of heat from the planar elements 61-64 towards the thermal conditioning channel 80. In an embodiment the material 83 is selected from a group consisting of a ceramic, a glass such as a borosilicate glass, an epoxy and an insulating adhesive.

By providing the material 83 between the planar elements 61-64 and the thermal conditioning channel 80, the distance between the planar elements 61-64 and the thermal conditioning channel 80 may be reduced. In an embodiment, a distance between the planar elements 61-64 and the thermal conditioning channel 80 is less than a distance between an edge of the planar elements 61-64 and a centre of the beam path. For example, in the view shown in Figure 8 or Figure 9 (i.e. parallel to the beam path), the shortest distance from the edge of the planar elements (which corresponds to the edge of the spacers 71, 72) and the thermal conditioning channel 80 (which corresponds to the location of the electrical insulator 81) is less than the distance from the edge of the planar elements to the centre of the beam path (which corresponds to the centre of the planar elements). A shorter distance between the planar elements and the thermal conditional channel 80 helps to increase flow of heat towards the heat sink, which is the thermal conditioning channel 80. This helps the temperature of the electron-optical module 41 to be controlled. The centre of the beam path may correspond to the centre of the aperture in the planar elements for the passage of an electron beam. When the planar elements comprise an aperture array (or an aperture grid), then the centre of the beam path corresponds to the centre of the aperture grid. The shorter distance may enable the electron-optical module 41 to be more compact than otherwise. A more compact electron-optical module 41 is easier to use considering the volume restrictions in the design of a charged particle device of for example an assessment apparatus.

In an embodiment a distance between the planar elements and the thermal conditioning channel 80 when viewed in a direction parallel to the beam path is less than a width of the thermal conditioning channel 80. In the views shown in Figure 8 and Figure 9 (which it is noted are schematic), the width of the thermal conditioning channel 80 corresponds to the width of the electrical insulator 81. The shortest distance from the edge of the spacer 71 and the electrical insulator 81 is less than the width (i.e. the dimension in the up-down direction in the drawings, which is a direction parallel to a plane of the planar elements 61-64) of the electrical insulator 81.

As shown in Figures 6-9, in an embodiment a surface of the thermal conditioning channel 80 facing a direction parallel to the beam path is covered with an electrical insulator 81. In an embodiment, the electrical insulator 81 comprises a material selected from a group consisting of ceramic and a glass such as a borosilicate glass.

In Figures 6 and 7 the surfaces of the thermal conditioning channel 80 facing directions parallel to the beam path are the upper surface and the lower surface in the orientation shown in the drawings. As shown in Figures 6 and 7, the upper surface, namely the upbeam surface of the thermal conditioning channel 80 is covered with an electrical insulator 81. The electrical insulator 81 is configured to electrically insulate the thermal conditioning channel 80 from other components of the electron-optical apparatus. The electrical insulator 81 is configured to decrease the possibility of electrical breakdown between the thermal conditioning channel 80 and one or more of the planar elements 61-64, for example. The electrical insulator 81 may form an insulating block. The electrical insulator 81 lengthens the creep path between the thermal conditioning channel 80 and the open parts of the stack, for example the central region of the most upbeam planar element 61 that is not covered by the most upbeam spacer 71.

In an embodiment the outward facing surface of the thermal conditioning channel 80 is covered with an electrical insulator. In the orientation shown in Figures 6 and 7, the outward facing surface of the thermal conditioning channel 80 is the surface that faces away from the planar elements 61-64. For example, the outward facing surface of the thermal conditioning channel 80 on the left-hand side of the drawing is the left-hand surface of the thermal conditioning channel 80. By covering the outward facing (relative to the beam paths) surface of the thermal conditioning channel 80, the creep path between the thermal conditioning channel 80 and the open part of the stack may be lengthened.

As shown in Figure 8, in an embodiment the material 83 goes completely around the stack of planar elements and spacers which are operated at high voltage during use of the electron-optical module 41. The material 83 fills the gap 82 between the thermal conditioning channel 80 and the stack. The material 83 helps to reduce enhancement of local electric fields in possible vacuum gaps. The use of the material 83 combines synergistically with the provision of the thermal conditioning channel 80 and the thermally conductive plate. In particular, the material 83 allows the thermal conditioning channel 80 to be closer to the stack such that heat is transferred a shorter distance through the thermally conductive plate towards the thermal conditioning channel 80.

In an embodiment the thermally conductive plate is monolithic. For example, the detector 240 may be monolithic. The detector spacer 75 may be monolithic. The downbeam spacer 74 between the planar element 63 and the planar element 64 may be monolithic. When the thermally conductive plate is monolithic, the thermally conductive plate may better transfer heat towards the thermal conditioning channel 80. In an embodiment the thermally conductive plate comprises a planar element such as the detector 240.

In an embodiment the detector 240 is secured to the thermally conductive plate. For example, the detector spacer 75 may constitute the thermally conductive plate. The detector 240 is secured to the detector spacer 75. In an embodiment, the detector 240 is comprised within the thermally conductive plate. For example, in an embodiment the thermally conductive plate is constituted by the detector 240 and the detector spacer 75. In an embodiment, the thermally conductive plate consists of the detector 240. The detector spacer 75 may be separate from the thermally conductive plate. The detector spacer 75 may be omitted. Alternatively the detector spacer 75 may be integral with the detector 240, the detector spacer 75 being formed of a similar electrically isolating and thermally conductive material as the detector 240.

As shown in Figures 6 and 7, in an embodiment the thermal conditioning channel 80 is secured to the detector 240 via the detector spacer 75. The detector spacer 75 is located between the thermal conditioning channel 80 and the detector 240. Heat transfers from the detector 240 to the thermal conditioning channel 80 via the detector spacer 75. In an alternative arrangement, the thermal conditioning channel 80 may be in direct contact with the detector 240. The detector spacer 75 may be omitted (e.g. integrated into the detector) or the detector spacer 75 may have an outer rim that is inward of the thermal conditioning channel 80.

In an embodiment, the thermally conductive plate is a planar element comprising an array of apertures for passage of one or more electron beams along the beam paths. For example, in an embodiment the thermally conductive plate is the detector 240. The detector 240 may comprise one or more apertures for passage of electron beams, for example different beams of a beam grid. In an alternative embodiment, the thermally conductive plate is connected to a planar element comprising an array of apertures for passage of one or more electron beams along the beam paths. For example, in an embodiment the thermally conductive plate is the detector spacer 75 or the spacer 74, each of which is connected to a planar element (e.g. the detector 240 or a planar element 63, 64) that comprises one or more apertures.

In an embodiment the planar element that is connected to the thermally conductive plate has a thickness in a direction parallel to the beam path greater than or substantially equal to a thickness of another of the planar elements. In an embodiment, at least one of the planar elements is connected to the thermally conductive plate. An individual planar element that is connected to the thermally conductive plate is secured to the thermally conductive plate. When there are multiple thermally conductive plates at least one of the planar elements may be conductive to each thermally conductive plate.

In an embodiment the thermally conductive plate may be, or may be connected to, an individual beam corrector plate or a deflector plate, for example. For example, in an embodiment the planar element that constitutes or is connected to the thermally conductive plate comprises a plurality of electrodes configured to apply electric fields for aberration corrections and/or deflections to one or more of the beam paths. The electrodes are arranged relative to respective apertures of an array of apertures. In an embodiment the electrodes of an aperture operate on one or a group of the beam paths. In an embodiment one or more electrodes operate on a beam path independently of other beam paths.

In an embodiment the planar element that constitutes or is connected to the thermally conductive plate is a multipole array. The multipole array is for operating on the electrons. For example, the multipole array may comprise individual beam deflectors, stigmators or may have another function of a corrector. In an embodiment the planar element comprises a plurality of individual deflectors configured to deflect electron beams at respective apertures independently of each other.

As mentioned above, in an embodiment the electron-optical module 41 comprises electronic circuitry, for example in a circuitry layer. The electronic circuitry may be comprised in the thermally conductive plate, for example in the detector 240 for example as a CMOS structure. In an embodiment the electronic circuitry has a higher density closer to the thermal conditioning channel 80 than a centre of the beam path. For example, as shown in Figures 6 and 7, in an embodiment the electronic circuitry is primarily located in a peripheral region 247 of the detector 240. As mentioned above, in an embodiment the electronic components comprise ADCs. Additionally or alternatively, the electronic components comprise trans-impedance amplifiers (TIAs).

In an embodiment the electron-optical module 41 comprises a further thermally conductive plate. For example, in an embodiment the further thermally conductive plate extends between the planar element 61-64 and the thermal conditioning channel 80. In an embodiment the thermal conditioning channel 80 is in contact with both the thermally conductive plate and the further thermally conductive plate. In an embodiment the thermal conditioning channel 80 is located between the two thermally conductive plates. By providing a further thermally conductive plate, thermal conduction towards the thermal conditioning channel 80 may be improved. This may help to control the temperature of the electron-optical module 41.

In an embodiment a plurality of thermally conductive plates are configured to transfer heat to the same thermal conditioning channel 80. This may improve heat transfer to a heat sink without requiring multiple thermal conditioning channels for cooling different planar elements.

As mentioned above, in an embodiment, the electron-optical module 41 is or comprises an objective lens assembly comprising an array of objective lenses 241. The objective lenses 241 are for focussing electron beams on to the sample location. Alternatively, the electron-optical module 41 may be a condenser lens assembly for generating a plurality of electron beams from a source beam and/or focussing the electron beams at an intermediate focus plane. In an embodiment the electron-optical module 41 is field replaceable. Alternatively the electron-optical module 41 may comprise a lens array for example for locating in a different position in the beam path such as a condenser lens array or an objective lens array, such as between two macro lenses e.g. a condenser lens and an objective lens, one of which may be a magnetic lens. The electron-optical module 41 can be removed from the electron-optical apparatus and/or inserted into the electron-optical apparatus without otherwise dismantling the electron-optical apparatus.

In an embodiment the electron-optical module 41 may be comprised in the electron-optical device 40 as shown in Figure 2 or Figure 3 or Figure 5 for example. In an embodiment the planar elements 61-64 of the electron-optical module 41 comprise a beam stop array. The beam stop array may be downbeam of another planar element such as a deflector array. The deflector array may be comprised in the same electron-optical module as the beam stop array. In an embodiment the beam stop array comprises an array of apertures for passage of beam paths. Individual deflectors of the deflector array may be configured to controllably operate on the individual electron beams or groups of beams to be blocked by the beam stop array or to be directed through an individual aperture.

The invention may be embodied as a method for moderating a temperature of one or more components of an electron-optical module 41. In an embodiment the method comprises arranging a plurality of planar elements 61-64 across the beam path to operate on the electrons. For example, the electron-optical module 41 may be mounted into an electron-optical device 41 of an electron-optical apparatus 100.

In an embodiment the method comprises spacing a thermal conditioning channel 80 from the planar element 61-64 in a direction through the plurality of planar elements 61-64. Heat is transferred towards the thermal conditioning channel 80 through a thermally conductive plate to the thermal conditioning channel 80. In an embodiment the thermally conductive plate extends between the planar elements 61-64 and the thermal conditioning channel 80 in a direction parallel to one or more of the planar elements 61-64. For example, the thermally conductive plate may be or may comprise a detector 240 as shown in Figures 6 and 7.

In an embodiment the invention is embodied as a method for moderating a temperature of one or more components of an electron-optical module 41. In an embodiment the method comprises operating the electron-optical apparatus 100 to project electrons to a sample location. In an embodiment the method comprises flowing thermal conditioning fluid through the thermal conditioning channel 80 and transferring heat towards the thermal conditioning channel 80 through the thermally conductive plates.

The electron-optical module 41 may comprise or be a lens assembly for manipulating electron beamlets. The lens assembly may, for example, be, or may be part of, an objective lens assembly or a condenser lens assembly. The lens assembly, such as an objective lens assembly, may further comprise an additional lens array comprising at least two plates such as a control lens array 250.

In an embodiment at least one of the planar elements 61-64, 240 comprises a micro-electro mechanical component. In an embodiment the electron-optical module 41 comprises one or more electron-optical elements which comprise an element which may be referred to as a microelectromechanical component (despite such component may not comprise a moving or moveable feature) or may be made using techniques suited to make microelectromechanical components (for example a 'MEMS technique') some of which are designed to have electron-optical functionality. The electron-optical module 41, or at least components of the electron-optical module 41, may be manufactured by such techniques. The electron-optical module 41 may comprise one or more elements which may be considered MEMS elements. One or more of such elements may be controlled to be set at a high potential difference relative to a reference potential (e.g. ground) during use. Such elements may require accurate positioning (for example alignment) within the electron-optical module 41 for example with respect to the path of the beam grid and with respect to other electron-optical elements within the device for example with respect to a source, with respect to a sample and/or the path of the beam grid. An embodiment of the invention is expected to allow for more accurate positioning (for example alignment) of such elements within the stack of such an electron-optical module 41 such as during operation for example without distortion of the electron-optical module 41 for example by externally applied force or moment. An embodiment of the invention may in addition or alternatively enable more accurate positioning, for example alignment, of such elements with respect to other elements in the electron-optical device 40 and thus of the stack of the electron-optical module 41 comprising such elements within the electron-optical device 40.

As mentioned above, in an embodiment the electron-optical module 41 is an electron-optical lens assembly. The electron-optical lens assembly may comprise an objective lens assembly. The electron-optical lens assembly may be an objective lens assembly. In an alternative embodiment the electron-optical lens assembly is an electron-optical condenser lens assembly.

In an embodiment the electron-optical module 41 comprises a collimator. For example, in an embodiment the electron-optical module 41 comprises a magnetic collimator in combination with an electro static condenser lens arrays. The electron-optical module 41 may comprise a single aperture lens array with one or two macro electrodes, placed away from the virtual source conjugate plane.

In an alternative embodiment, the electron-optical module 41 comprises a magnetic macro lens in combination with an electrostatic slit deflector. The magnetic macro lens may be for collimating. As a further alternative, in an embodiment the electron-optical module 41 comprises a combined magnetic and electrostatic macro lens and a downbeam slit deflector.

In general, the electron-optical module 41 may comprise any plates such as a plate of a detector array, a plate of a lens electrode (into which multiple deflectors may be integrated) multiple deflector arrays, beam aperture arrays (e.g. an upper beam aperture array and/or a final beam limiting array), deflector arrays (e.g. strip deflector arrays) and other types of corrector elements.

The embodiments described within this document have focussed primarily on multi-beam electron-optical devices 40. The invention is equally applicable to single-beam electron-optical devices 40.

A plurality of electron-optical devices may be comprised in an electron-optical device array. The electron-optical devices of the electron-optical device array are preferably be configured to focus respective multi-beams simultaneously onto different regions of the same sample.

While the present invention has been described in connection with various embodiments, other embodiments of the invention will be apparent to those skilled in the art from consideration of the specification and practice of the invention disclosed herein. For example, as described above in an embodiment the electron-optical module 41 comprises the planar elements 61-64, the thermal conditioning channel 80 and the material 83. However, the planar elements 61-64, the thermal conditioning channel 80 and/or the material 83 of the invention can be used anywhere in the electron-optical device 40 where a problem of possible undesirable heating and/or electrical breakdown may exist. In an embodiment the electron-optical device 40 comprises the planar elements 61-64, the thermal conditioning channel 80 and the material 83 separately from the electron-optical module 41. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.

There is provided the following clauses:
Clause 1. A charged particle-optical module for directing charged particles along a beam path towards a sample location, the charged particle-optical module comprising: a plurality of planar elements arranged across the beam path and configured to operate on the charged particles; a thermal conditioning channel spaced from the planar elements in a direction through the plurality of elements; and a thermally conductive plate connected to the thermal conditioning channel for transferring heat towards the thermal conditioning channel; wherein the thermally conductive plate extends between the planar elements and the thermal conditioning channel in a direction parallel to one or more of the planar elements.
Clause 2. The charged particle-optical module of clause 1, comprising a material electrically isolating the planar elements from the thermal conditioning channel.
Clause 3. The charged particle-optical module of clause 2, wherein the material surrounds one or more of the planar elements.
Clause 4. The charged particle-optical module of clause 2 or 3, wherein the material continuously fills, desirably completely fills, a volume between one or more planar elements, desirably all the planar elements and the thermal conditioning channel, desirably the volume has a surface is defined by at least one of: a portion of a surface of the thermally conductive plate desirably parallel to one or more of the planar elements; a surface the channel desirably facing one or more of the planar elements; an outer surface of one or more planar elements; and one or more spacers between adjoining planar elements; and/or between an individual planar element and the thermally conductive plate.
Clause 5. The charged particle-optical module of any of clauses 2-4, wherein the material electrically isolates the thermal conditioning channel from one or more electrical connectors for electrically connecting one or more of the planar elements to an electrical cable.
Clause 6. The charged particle-optical module of any of clauses 2-5, wherein the material is selected from a group consisting of a ceramic, a glass such as a borosilicate glass, an epoxy and an insulating adhesive.
Clause 7. The charged particle-optical module of any preceding clause, wherein a distance between the planar elements and the thermal conditioning channel is less than a distance between an edge of the planar elements and a centre of the beam path.
Clause 8. The charged particle-optical module of any preceding clause, wherein a distance between the planar elements and the thermal conditioning channel when viewed in a direction parallel to the beam path is less than a width of the thermal conditioning channel.
Clause 9. The charged particle-optical module of any preceding clause, wherein a surface of the thermal conditioning channel facing a direction parallel to the beam path is covered with an electrical insulator.
Clause 10. The charged particle-optical module of any preceding clause, wherein a surface of the thermal conditioning channel facing away from the beam path is covered with an electrical insulator.
Clause 11. The charged particle-optical module of any preceding clause, wherein the thermally conductive plate is monolithic, desirably comprising a planar element.
Clause 12. The charged particle-optical module of any preceding clause, wherein the thermally conductive plate is, or is connected to, a planar element such as a detector for detecting charged particles for example signal particles from the sample location.
Clause 13. The charged particle-optical module of clause 12, wherein the detector has a thickness in a direction parallel to the beam path greater than or substantially equal to a thickness of one or more of the planar elements, desirably the detector is configured to conduct heat generated in the detector during operation towards the thermal conditioning channel, desirably the thickness is dimensioned and/or the detector comprises a material having a thermal conductivity sufficient to conduct the heat generated in the detector during operation towards the thermal conditioning channel.
Clause 14. The charged particle-optical module of clause 12 or 13, wherein the detector is secured to, desirably comprised within, the thermally conductive plate, desirably the thermally conductive plate consists of the detector.
Clause 15. The charged particle-optical module of any preceding clause, wherein the thermally conductive plate is, or is connected to, a planar element comprising: an array of apertures for passage of one or more beam paths.
Clause 16. The charged particle-optical module of clause 15, wherein said planar element has a thickness in a direction parallel to the beam path greater than or substantially equal to a thickness of another of the planar elements.
Clause 17. The charged particle-optical module of clause 15 or 16, wherein said planar element is secured to the thermally conductive plate.
Clause 18. The charged particle-optical module of any of clauses 15-17, wherein said planar element comprises plurality of electrodes configured to apply aberration corrections to one or more of the beam paths, the electrodes being arranged relative to respective apertures of the array of apertures, desirably the electrodes of an aperture operating on one or a group of the beam paths, desirably one or more electrodes operating on a beam path independently of other beam paths.
Clause 19. The charged particle-optical module of any of clauses 15-18, wherein said planar element is a multipole array for operating on the charged particles such as an individual beam deflector, stigmator or other function of corrector comprising: a plurality of individual deflectors configured to deflect charged particle beams at respective apertures independently of each other.
Clause 20. The charged particle-optical module of any preceding clause, wherein at least one of the planar elements is a beam limiting aperture array configured to shape, derisibly to generate, one or more beams of charged particles.
Clause 21. The charged particle-optical module of any preceding clause, comprising electronic circuitry, desirably in a circuitry layer, desirably in the thermally conductive plate and/or detector, desirably the electronic circuitry having a higher density closer to the thermal conditioning channel than a centre of the beam path, desirably a plurality of electronic components located closer to the thermal conditioning channel than to a centre of the beam path.
Clause 22. The charged particle-optical module of clause 21, wherein the electronic components comprise analogue-to-digital converters and/or trans-impedance amplifiers.
Clause 23. The charged particle-optical module of any preceding clause, wherein the thermally conductive plate comprises, or is connected to a component that comprises, a CMOS device.
Clause 24. The charged particle-optical module of any preceding clause, comprising a plurality of thermal conditioning channels extending along different sides of the planar elements, desirably two or more of the thermal conditioning channels are separate, desirably two or more of the thermally conditioning channels are connected desirably in parallel and/or series.
Clause 25. The charged particle-optical module of any proceeding clause, wherein the one or more thermal conditioning channels extend around the charged particle-optical module.
Clause 26. The charged particle-optical module of clause 25, wherein the one or more thermal conditioning channels extend around the charged particle-optical module more than once, desirably multiple times, desirably helically.
Clause 27. The charged particle-optical module of any preceding clause, comprising a further thermally conductive plate, desirably the further conductive plate extending between the planar elements and the thermal conditioning channel, desirably the thermal conditioning channel is in contact with the thermally conductive plate and the further thermally conductive plate between the two thermally conductive plates.
Clause 28. The charged particle-optical module of any preceding clause, comprising one or more spacer elements between two adjoining planar elements of the plurality of planar elements, an individual spacer element configured to support and/or electrically isolate the adjoining planar elements, desirably an outer surface of the spacer element defines in part the surface of the volume between the plurality of planar elements.
Clause 29. The charged particle-optical module of any preceding clause, wherein at least one of the planar elements comprises a microelectromechanical component.
Clause 30. The charged particle-optical module of any preceding clause, wherein the charged particle-optical module is or comprises: an objective lens assembly comprising an array of objective lenses for focusing charged particle beams onto the sample location; or a condenser lens assembly for generating a plurality of charged particle beams from a source beam and/or focussing the plurality of beams at an intermediate focus plane.
Clause 31. A charged particle-optical device for directing charged particles onto a sample location, the charged particle-optical device comprising the charged particle-optical module of any preceding clause.
Clause 32. The charged particle-optical device of clause 31, wherein the planar elements comprise a beam stop array, desirably downbeam of another planar element that is a deflector array, wherein the deflector array may be comprised in the same charged particle-optical module as the beam stop array, the beam stop array comprising an array of apertures for passage of beam paths, wherein individual deflectors of the deflector array are configured to controllably operate on the individual beams or beam groups to be blocked by the beam stop array or to be directed through an individual aperture.
Clause 33. A charged particle-optical apparatus comprising the charged particle-optical module of any of clauses 1-30 or the charged particle-optical device of clause 31 or 32.
Clause 34. The charged particle-optical apparatus of clause 33, further comprising an actuatable stage for supporting a sample at the sample location.
Clause 35. A method for moderating a temperature of one or more components of a charged particle-optical module for directing charged particles along a beam path towards a sample location, the method comprising: arranging a plurality of planar elements across the beam path to operate on the charged particles, for example mounting the module into a charged particle-optical device of a charged particle-optical apparatus; spacing a thermal conditioning channel from the planar elements in a direction through the plurality of elements; and transferring heat towards the thermal conditioning channel through a thermally conductive plate connected to the thermal conditioning channel; wherein the thermally conductive plate extends between the planar elements and the thermal conditioning channel in a direction parallel to one or more of the planar elements.
Clause 36. A method for moderating a temperature of one or more components of a charged particle-optical module for use in a charged particle-optical apparatus to direct charged particles along a beam path towards a sample location, the charged particle-optical module comprising a plurality of planar elements configured to operate on charged particles, a thermal conditioning channel spaced away from the plurality of planar elements, and a thermally conductive plate extending between and in thermal contact with the plurality of planar elements and the thermal conditioning channel, the method comprising: operating the charged particle-optical apparatus to project charged particles to a sample location; flowing thermal conditioning fluid through the thermal conditioning channel; and transferring heat towards the thermal conditioning channel through the thermally conductive plate.

## Claims

1. A charged particle-optical module for directing charged particles along a beam path towards a sample location, the charged particle-optical module comprising:
a plurality of planar elements arranged across the beam path and configured to operate on the charged particles;
a thermal conditioning channel spaced from the planar elements in a direction through the plurality of elements; and
a thermally conductive plate connected to the thermal conditioning channel for transferring heat towards the thermal conditioning channel;
wherein the thermally conductive plate extends between the planar elements and the thermal conditioning channel in a direction parallel to one or more of the planar elements.

2. The charged particle-optical module of claim 1, comprising a material electrically isolating the planar elements from the thermal conditioning channel.

3. The charged particle-optical module of claim 2, wherein the material surrounds one or more of the planar elements.

4. The charged particle-optical module of claim 2 or 3, wherein the material continuously fills, desirably completely fills, a volume between one or more planar elements, desirably all the planar elements and the thermal conditioning channel, desirably the volume has a surface is defined by at least one of:
a. a portion of a surface of the thermally conductive plate desirably parallel to one or more of the planar elements;
b. a surface the channel desirably facing one or more of the planar elements;
c. an outer surface of one or more planar elements; and
d. one or more spacers
i. between adjoining planar elements; and/or
ii. between an individual planar element and the thermally conductive plate.

5. The charged particle-optical module of any preceding claim, wherein a distance between the planar elements and the thermal conditioning channel is less than a distance between an edge of the planar elements and a centre of the beam path and/or wherein a distance between the planar elements and the thermal conditioning channel when viewed in a direction parallel to the beam path is less than a width of the thermal conditioning channel.

6. The charged particle-optical module of any preceding claim, wherein a surface of the thermal conditioning channel facing a direction parallel to the beam path is covered with an electrical insulator and/or wherein a surface of the thermal conditioning channel facing away from the beam path is covered with an electrical insulator.

7. The charged particle-optical module of any preceding claim, wherein the thermally conductive plate is monolithic, desirably comprising a planar element and/or wherein the thermally conductive plate is, or is connected to, a planar element such as a detector for detecting signal particles from the sample location.

8. The charged particle-optical module of claim 7, wherein the detector is secured to, desirably comprised within, the thermally conductive plate, desirably the thermally conductive plate consists of the detector.

9. The charged particle-optical module of any preceding claim, wherein the thermally conductive plate is, or is connected to, a planar element comprising:
an array of apertures for passage of one or more beam paths.

10. The charged particle-optical module of claim 9, wherein said planar element comprises plurality of electrodes configured to apply aberration corrections to one or more of the beam paths, the electrodes being arranged relative to respective apertures of the array of apertures,.

11. The charged particle-optical module of any preceding claim, wherein at least one of the planar elements is a beam limiting aperture array configured to shape one or more beams of charged particles.

12. The charged particle-optical module of any preceding claim, comprising electronic circuitry, desirably in a circuitry layer, in the thermally conductive plate and/or detector.

13. The charged particle-optical module of any preceding claim, comprising a plurality of thermal conditioning channels extending along different sides of the planar elements.

14. The charged particle-optical module of any preceding claim, comprising one or more spacer elements between two adjoining planar elements of the plurality of planar elements, an individual spacer element configured to support and/or electrically isolate the adjoining planar elements.

15. A charged particle-optical device for directing charged particles onto a sample location, the charged particle-optical device comprising the charged particle-optical module of any preceding claim.
